# EUROPEAN PATENT APPLICATION

(11) **EP 1 705 699 A1**
(43) Date of publication of application: **27.09.2006**
(21) Application number: 04807596.4
(22) Date of filing: 22.12.2004
(51) Int. Cl.: H01L 21/205, C23C 16/455

(54) **FILM FORMING DEVICE AND FILM FORMING METHOD**

(30) Priority: 05.01.2004 JP 2004000685
(71) Applicant: HORIBA, LTD., Kyoto-shi, Kyoto 601-8510 (JP); Renesas Technology Corp., Tokyo 100-6334 (JP); ROHM CO., LTD., Kyoto-shi, Kyoto 615-8585 (JP)
(72) Inventor: TOMINAGA, Koji, Kyoto-city Kyoto 6018510 (JP); YASUDA, Tetsuji, Tsukuba-shi (JP); NABATAME, Toshihide, Chiyoda-ku Tokyo 1006334 (JP); IWAMOTO, Kunihiko, Kyoto-shi Kyoto 6158585 (JP)
(74) Representative: Cross, Rupert Edward Blount
(86) International application number: PCT/JP2004/019239
(87) International publication number: WO 2005/067015

(57) **Abstract**

A throughput during a process of forming a thin film is improved and a thin film of high quality is produced at low cost.

For this purpose, a film forming system comprises a chamber 8, a precursory gas supplying line 2 to supply the chamber 8 with precursory gas, a reactive gas supplying line 1 to supply the chamber 8 with reactive gas, and a purge gas supplying line 3 to supply purge gas that purges the precursory gas and the reactive gas, and forms a thin film on a substrate 82 in the chamber 8 by supplying the precursory gas or the reactive gas and purging alternately, and further comprises a middle line 22 having a certain volume that is arranged on a part or all of the precursor supplying line 2 and into which the precursory gas can be filled at a time when the precursory gas is not supplied, and/or a middle line 12 having a certain volume that is arranged on a part or all of the reactive gas supplying line 1 and into which the reactive gas can be filled at a time when the reactive gas is not supplied.

## Description

### FIELD OF THE ART

This invention relates to an atomic layer control film forming system used for forming a metal-oxide film, a metal nitride film and a metal oxynitride film that constitute a semiconductor unit.

### BACKGROUND ART

The ALD (atomic layer deposition) is a method for depositing a film consisting of a material of a single layer sequentially and individually and is superior in depositing a strictly administrated layer while the CVD (chemical vapor deposition) is a method for continuously depositing a film by inpouring a material ceaselessly. The ALD forms a thin film by exposing a surface of a substrate on which the film is deposited to precursory gas and reactive gas that reacts with the precursory gas alternately and this method requires a process to conduct gas flushing of an inside of a chamber by the use of purge gas such as inert gas prior to introducing the precursory gas and the reactive gas.
Patent document 1 Japan patent laid-open number 2001-152339
Patent document 2 Japan patent laid-open number 2003-226970

### DISCLOSURE OF THE INVENTION

### PROBLEM TO BE SOLVED BY THE INVENTION

With the arrangement requiring the gas flushing, since it takes time to form the thin film due to an operation of the gas flushing, there is a problem that the throughput is aggravated. In addition, if the gas flushing of the inside of the chamber by the use of the purge gas is inadequate, residual gas of the precursory gas reacts with residual gas of the reactive gas in the chamber and particles (nucleation in gaseous phase) are generated. As a result of this, there is a problem that the quality of the thin film is aggravated.

Then the present claimed invention mainly intends to produce a thin film of high quality at lower cost by improving the throughput during a process of forming the thin film and preventing the quality of the thin film from being aggravated due to generation of the particles and further improving the quality of the thin film with strict administration of the volume of the gas.

### MEANS TO SOLVE THE PROBLEMS

The film forming system of the present claimed invention comprises a chamber, a precursory gas supplying line to supply the chamber with precursory gas, a reactive gas supplying line to supply the chamber with reactive gas, and a purge gas supplying line to supply purge gas that purges the precursory gas and/or the reactive gas, and forms a thin film on a substrate in the chamber by supplying the precursory gas or the reactive gas supply and purging alternately, and further comprises a middle line having a certain volume that is arranged on a part or all of the precursor supplying line and into which the precursory gas can be filled at a time when the precursory gas is not supplied, and/or a middle line having a certain volume that is arranged on a part or all of the reactive gas supplying line and into which the reactive gas can be filled at a time when the reactive gas is not supplied. This arrangement makes it possible to fill the precursory gas or the reactive gas preliminarily at a time when the precursory gas or the reactive gas is not supplied so that the time required for supplying the gas necessary to form the film is shortened, thereby to considerably improve the throughput.

Concretely, it is preferable to set that the precursory gas or the reactive gas can be filled into the middle line by arranging a switching valve on an inlet port and an outlet port of the middle line respectively and it is possible to improve the quality of the film by controlling a volume of the gas inside the line by the use of the middle line whose volume is known.

Furthermore, if the switching valve arranged on the inlet port and the outlet port of the middle line is a three-way valve such as a three-way electromagnetic valve that has three ports as being an electromagnetic valve that is driven at high speed by electromagnetic force, it is possible to shorten the time required for forming the film so as to improve the throughput of film forming and to prevent particles from being generated by avoiding the gas from stagnating in the line.

With an arrangement wherein the purge gas supplying line is connected to the precursory gas supplying line to which the middle line is arranged and/or the reactive gas supplying line to which the middle line is arranged and the precursory gas and/or the reactive gas each of which is filled in the middle line is supplied to the chamber by pushing out the precursory gas and/or the reactive gas by the use of the purge gas, it is possible to introduce the precursory gas in the middle line into the chamber completely at a time of purging the precursory gas or the reactive gas. As a result, an amount of the precursory gas or the reactive gas to be supplied to the chamber can be strictly controlled and particles are prevented from being generated in the precursory gas supplying line or the reactive gas supplying line by purging a part of the precursory gas supplying line or the reactive gas supplying line locating from the outlet of the middle line to a side of the chamber. In addition, the time required for supplying the precursory gas or the reactive gas can be saved by overlapping the time required for initiation of supplying the purge gas and the time to require for supplying the gas filled in the middle line, thereby to improve the throughput of film forming considerably.

In addition, the precursory gas and/or the reactive gas is supplied to the chamber in 0.1 through 2 second. More specifically, in case of sending out the precursory gas or the reactive gas from the middle line to the chamber by the use of the purge gas, a volume obtained from a diameter and a length of a line of an interlinking portion from the inlet of the middle line to the chamber is adjusted so as to be replaced by the purge gas flow in 0.1 second - 2 second. This makes it possible to purge the precursory gas and/or the reactive gas from the middle line in a short time, thereby to suppress generation of the particles and to considerably improve the throughput of film forming.

With an arrangement wherein a concentration adjusting device to adjust each concentration of the precursory gas and the reactive gas is connected to the precursory gas supplying line and the reactive gas supplying line respectively to which the middle line is arranged and each concentration adjusting device adjusts each concentration of the precursory gas and the reactive gas so as to supply each gas at more than or equal to 0.15 × 10⁻⁶ mol/cm² with respect to an area of the substrate on which a thin film is formed, it is possible to deposit the thin film of high quality in a short time.

With an arrangement wherein each of the precursory gas supplying line and the reactive gas supplying line is independently connected to the chamber, it is possible to prevent reaction of the gas molecule attaching inside the line so as to suppress generation of the particles.

In case of replacing an inside of the chamber by the purge gas, it is possible to completely replace the inside of the chamber by the purge gas by adjusting each concentration of the precursory gas and/or the reactive gas becomes less than or equal to 1/1000 in less than or equal to 2 seconds. With this arrangement, it is possible to improve the throughput of film forming without generating the particles.

### EFFECT OF THE INVENTION

In accordance with the present claimed invention, it is possible to form a thin film of high quality without generating particles in a short time. This improves the throughput of film forming, thereby to lower a cost of a product that makes use of film forming. Especially, with the film forming system and the film forming method of the present claimed invention it is possible to form a gate insulating film, a gate electrode film and a capacitor insulating film of high quality with the extremely superior throughput, thereby to lower a cost of a product that makes use of the film forming.

### BRIEF DESCRIPTION OF THE DRAWINGS

Fig. 1 is a schematic diagram showing an outline of the film forming system in accordance with one embodiment of the present claimed invention.
Fig. 2 is a view showing an example of an operating state of the film forming system in accordance with the embodiment.
Fig. 3 is a view showing an example of an operating state of the film forming system in accordance with the embodiment.
Fig. 4 is a view showing an example of an operating state of the film forming system in accordance with the embodiment.
Fig. 5 is a view showing an example of an operating state of the film forming system in accordance with the embodiment.
Fig. 6 is a view showing an example of an operating state of the film forming system in accordance with the embodiment.
Fig. 7 is an image view of the change over time of the gas supplied to the chamber.
Fig. 8 is a schematic diagram showing an outline of another embodiment comprising a two-port valve in accordance with the present claimed invention.
Fig. 9 is a schematic diagram showing an outline of a further different embodiment in accordance with the present claimed invention wherein the concentration of the gas in the precursory gas middle line and the reactive gas middle line can be controlled.
Fig. 10 is a graph showing a relationship between the purge time and attenuation of the concentration of the remaining precursory gas at a time when the pressure in the chamber is 0.1 - 20 Torr.
Fig. 11 is a schematic diagram showing an outline of a further different embodiment in accordance with the present claimed invention wherein a part of each middle line output part of the precursory gas and the reactive gas is shared.
Fig. 12 is a schematic diagram showing an outline of a further different embodiment in accordance with the present claimed invention in case of conducting film forming by the use of multiple kinds of precursory gas.
Fig. 13 is a schematic diagram showing an outline of a further different embodiment in accordance with the present claimed invention wherein a part of the supplying line is shared in case of conducting film forming by the use of multiple kinds of precursory gas.
Fig. 14 is a graph showing a relationship between an amount of the reactive gas (H₂O) to be supplied and the deposition rate.
Fig. 15 is a graph showing a relationship between an amount of TDMAH gas to be supplied and the deposition rate.
Fig. 16 is a table showing a relationship between an inside diameter of the supplying gas line and an amount of particles in case that the line length is set to be 100 mm.
Fig. 17 is a table showing a comparison result concerning the amount of the particles and uniformity of the film pressure between a case that the supplying line is independently arranged and a case that the supplying line is shared.
Fig. 18 is a table showing a comparison result between the throughput of the film forming system by the use of the present claimed invention and the throughput of the film forming system by the use of a conventional technique.

### EXPLANATION OF CODE

1. reactive gas supplying line 12. middle line (reactive gas middle line) 1b1. reactive gas middle line inlet valve 1b2. reactive gas middle line outlet valve 2. precursory gas supplying line 22. middle line (precursory gas middle line) 2b1. precursory gas middle line inlet valve 2b2. precursory gas middle line outlet valve 3. purge gas supplying line 8. chamber 82. substrate

### BEST MODES OF EMBODYING THE INVENTION

The film forming system in accordance with this invention comprises a chamber, a precursory gas supplying line that supplies the chamber with precursory gas, a reactive gas supplying line that supplies the chamber with reactive gas, and a purge gas supplying line that supplies purge gas that purges the precursory gas and the reactive gas, and forms a thin film on a substrate of semiconductor in the chamber by supplying precursory gas or reactive gas and conducting purge alternately.

A precursory gas middle line 22 as a middle line having a certain volume is arranged on a part of the precursory gas supplying line and a reactive gas middle line 12 as a middle line having a certain volume is arranged on a part of the reactive gas supplying line.

An example of conducting film forming is shown; an Al₂O₃ film as a thin film is deposited on a substrate 82 of Si with TMA (trimethyl aluminum) Al(CH₃)₃ used as the precursory gas and H₂O used as the reactive gas. Ar gas is used as the purge gas and carrier gas.

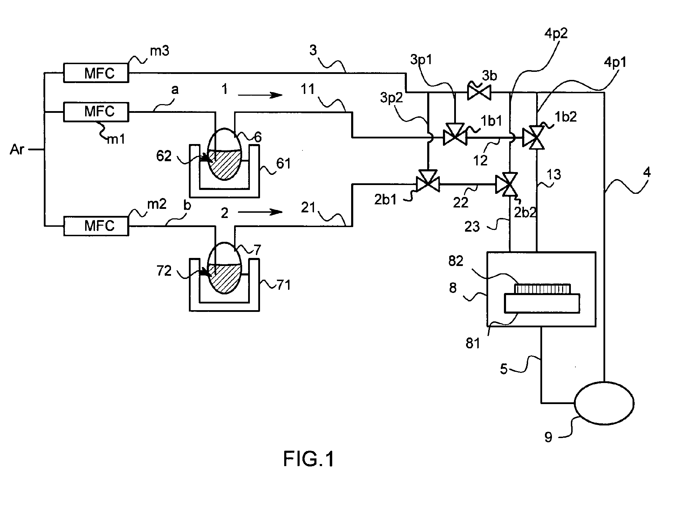

A schematic diagram of the system is shown in Fig. 1.

The film forming system comprises three mass flow controllers (abbreviated as MFC) m1, m2, m3 to send out Ar gas as the carrier gas and the purge gas, a reactive gas tank 6 to store H₂O as being the reactive gas 62, a precursory gas tank 7 to store TMA as being the precursory gas 72, a chamber 8 to form the thin film and a pump 9 to suck each gas and to keep the inside of the chamber 8 depressurized.

Each component will be described in detail.

The MFC m1, m2, m3 controls a flow rate of the carrier gas or the purge gas. The MFC m1 is set to send out the carrier gas or the purge gas at about 180 ml/min, the MFC m2 at about 60 ml/min, and the MFC m3 at about 200 ml/min.

The reactive gas tank 6 is arranged to keep H₂O at about 25 °C by the use of a constant temperature water tank for reactive gas 61 and to output the reactive gas (H₂O) by receiving the carrier gas.

The precursory gas tank 7 is arranged to keep TMA at about 20 °C by the use of a constant temperature water tank for precursory gas 71 and to output the precursory gas (TMA) by receiving the carrier gas.

The chamber 8 is kept in a depressurized state of about 10 - 0.1 Torr and comprises a heater 81 that conducts resistance heating. The heater 81 is set to make the surface temperature of the substrate 82 of Si placed on the heater 81 at 250 - 300 °C.

The pump 9 is both for sucking each gas and for keeping the inside of the chamber 8 depressurized.

The line between each part will be explained as follows.

The MFC m1 is connected to the reactive gas tank 6 through a carrier gas supplying line for reactive gas a and the reactive gas tank 6 is connected to the chamber 8 through a reactive gas supplying line 1.

The MFC m2 is connected to the precursory gas tank 7 through a carrier gas supplying line for precursory gas b and the precursory gas tank 7 is connected to the chamber 8 through a precursory gas supplying line 2.

Each of the reactive gas supplying line 1 and the precursory gas supplying line 2 is a line that is independently arranged each other and a flow path for each gas is independent. Then the gas flowing inside each line 1, 2 is not mixed in the line 1, 2.

The chamber 8 is connected to the pump 9 through an exhaust line 5.

An inlet of a purge gas supplying line 3 is mounted on the MFC m3, an outlet of a bypath line 4 (bypath line) is mounted on the pump 9, and an outlet of the purge gas supplying line 3 and an inlet of the bypath line 4 are connected through a switching valve 3b that can make an open and close movement.

Next, each line will be explained for detail with explaining connection of each line.

Two three-way valves 1b1, 1b2 each of which furcates in three directions are arranged on a flow path of the reactive gas supplying line 1 and the reactive gas middle line 12 is formed between the three-way valves 1b1 and 1b2 by dividing the reactive gas supplying line 1 by the use of a pair of the three-way valves 1b1, 1b2. A volume of the reactive gas middle line 12 is about 15 ml.

The reactive gas supplying line 1 comprises a reactive gas middle line input part 11 that inputs the reactive gas to the reactive gas middle line 12, the reactive gas middle line 12 to which the reactive gas can be filled, and a reactive gas middle line output part 13 that outputs the reactive gas to the chamber 8.

The three-way valve can determine a direction to which the gas is sent by closing an arbitrary port among three ports. The three-way valve 8 used in this embodiment is a three-way magnetic valve driven by electromagnetic force, however, it may be of an air driven type.

The three-way valve (the reactive gas middle line inlet valve) 1b1 arranged at an inlet of the reactive gas middle line 12 is connected to the reactive gas middle line input part 11, the reactive gas middle line 12 and a purge gas supplying branch line for reactive gas 3p1 that connects between lines, and the purge gas supplying branch line for reactive gas 3p1 is connected to the purge gas supplying line 3.

The three-way valve (the reactive gas middle line outlet valve) 1b2 arranged at an outlet of the reactive gas middle line 12 is connected to the reactive gas middle line 12, the reactive gas middle line output part 13 and a bypath branch line for reactive gas 4p1 that connects between lines, and the bypath branch line for reactive gas 4p1 is connected to the bypath line 4.

Two three-way valves 2b1, 2b2 each of which furcates in three directions are arranged on a flow path of the precursory gas supplying line 2 and the precursory gas middle line 22 is formed between the three-way valves 2b1 and 2b2 by dividing the precursory gas supplying line 2 by the use of a pair of the three-way valves 2b1, 2b2. A volume of the precursory gas middle line 22 is about 5 ml.

The precursory gas supplying line 2 comprises a precursory gas middle line input part 21 that input the precursory gas to the precursory gas middle line 22, the precursory gas middle line 22 to which the precursory gas can be filled, and a precursory gas middle line output part 23 that outputs the precursory gas to the chamber 8.

The three-way valve (the precursory gas middle line inlet valve) 2b1 arranged at an inlet of the precursory gas middle line 22 is connected to the precursory gas middle line input part 21, the precursory gas middle line 22 and a purge gas supplying branch line for precursory gas 3p2 that connects between lines, and the purge gas supplying branch line for precursory gas 3p2 is connected to the purge gas supplying line 3.

The three-way valve (the precursory gas middle line outlet valve) 2b2 arranged at an outlet of the precursory gas middle line 22 is connected to the precursory gas middle line 22, the precursory gas middle line output part 23 and a bypath branch line for precursory gas 4p2 that connects between lines, and the bypath branch line for precursory gas 4p2 is connected to the bypath line 4.

Followings are an outline of the behavior of the film forming system.

The precursory gas (TMA) and the reactive gas (H₂O) are vaporized by a method such as a bubbling method and supplied to the chamber 8 by the carrier gas through the precursory gas supplying line 2 and the reactive gas supplying line 1 respectively.

A device to supply the gas will be explained including movements of each valve.

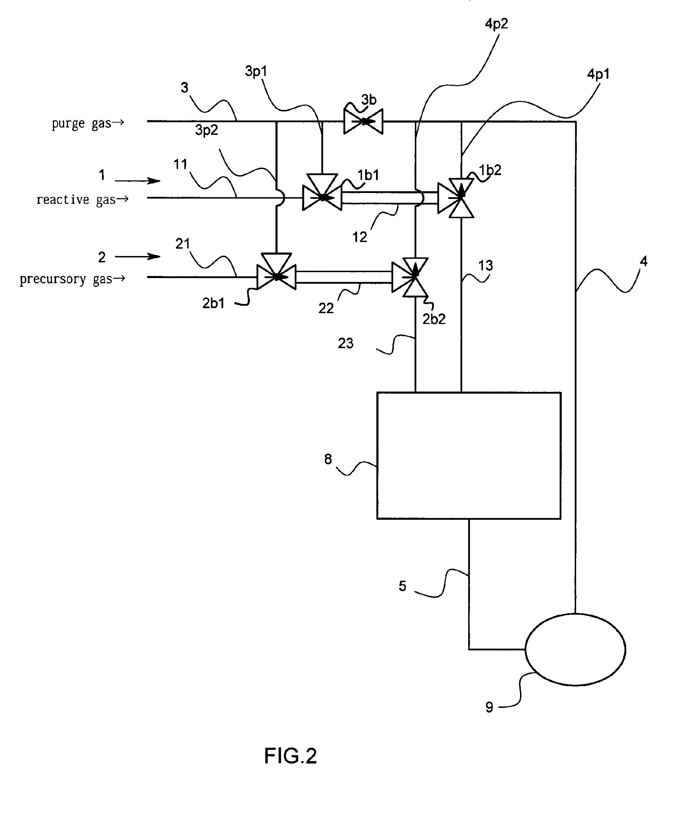

An enlarged view of the valve is shown in Fig. 2. In a preliminary stage prior to forming the film, the valves 1b1, 1b2, 2b1, 2b2 send out each gas to a direction shown as follows respectively.

The switching valve 3b is open and the purge gas is sent out to the bypath line 4. The reactive gas middle line inlet valve 1b1 closes a port at a side of the purge gas supplying branch line for reactive gas 3p1 so as to send out the reactive gas to the reactive gas middle line 12. The reactive gas middle line outlet valve 1b2 closes a port at a side of the reactive gas middle line output part 13 so as to send out the reactive gas to the bypath line 4 through the bypath branch line for reactive gas 4p1. The precursory gas middle line inlet valve 2b1 closes a port at a side of the purge gas supplying branch line for precursory gas 3p2 so as to send out the precursory gas to the precursory gas middle line 22. The precursory gas middle line outlet valve 2b2 closes a port at a side of the precursory gas middle line output part 23 so as to send out the precursory gas to the bypath line 4 through the bypath branch line for precursory gas 4p2. The direction to which the gas is sent out from each valve 1b1, 1b2, 2b1, 2b2 is shown by an arrow in Fig. 2.

First, the precursory gas (TMA) is supplied in initiating a process of film forming.

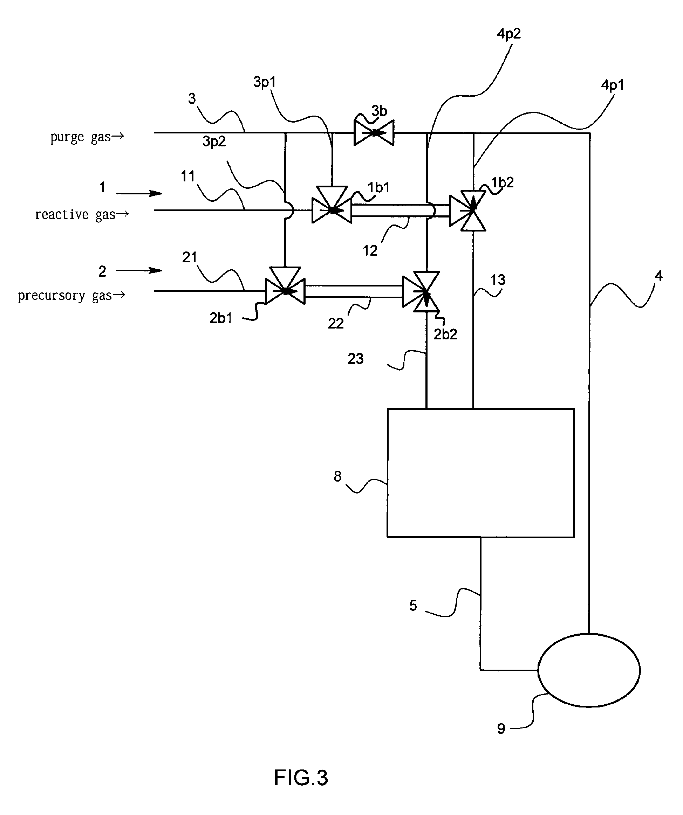

The precursory gas is sent out to the precursory gas middle line output part 23 by closing the port locating at a side of the bypath branch line for precursory gas 4p2 of the precursory gas middle line outlet valve 2b2 so as to be in a state shown in Fig. 3 and the precursory gas (TMA) is supplied to the chamber 8. The state shown in Fig. 3 continues for about 0.5 second. This period is controlled by an acting time of the valve and it may be shorter.

Then the precursory gas is deposited on the substrate and purged.

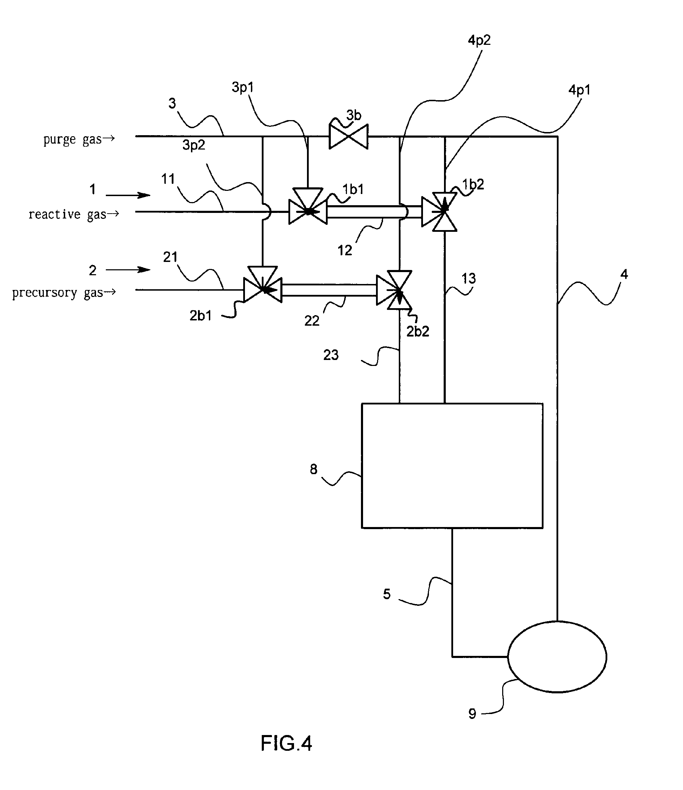

The purge gas is sent out to the precursory gas middle line 22 by closing the switching valve 3b and a port locating at a side of the precursory gas middle line input part 21 of the precursory gas middle line outlet valve 2b1 so as to be in a state shown in Fig. 4. Then the precursory gas (TMA) of volume (5 ml) in the precursory gas middle line 22 is pushed out to the chamber 8 so as to deposit the precursory gas on the substrate and then inside of the precursory gas middle line 22, inside of the precursory gas middle line output part 23 and inside of the chamber 8 are purged. The state in Fig. 4 continues for about 5 second.

The reactive gas is filled in the reactive gas middle line 12 during a period from the initiation of supplying the precursory gas (TMA) to the completion of purging the inside of the chamber 8.

Next, the reactive gas (H₂O) is supplied.

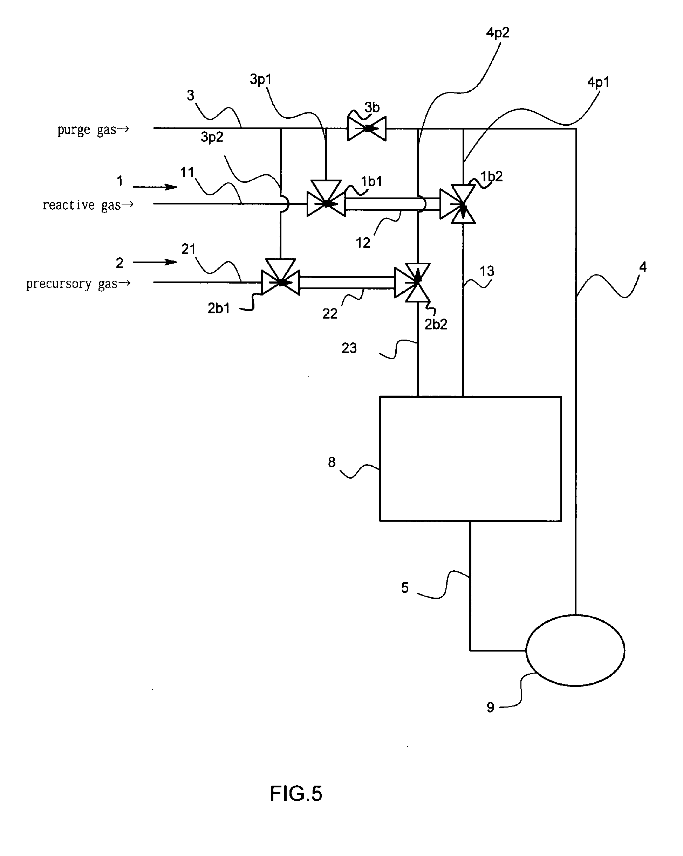

The switching valve 3b is open and the purge gas is sent out to the bypath line 4, a port at a side of the purge gas supplying branch line for precursory gas 3p2 of the precursory gas middle line inlet valve 2b1 is closed and the precursory gas is sent out to the precursory gas middle line 22, a port at a side of the precursory gas middle line output part 23 of the precursory gas middle line outlet valve 2b2 is closed and the precursory gas is sent out to the bypath branch line for precursory gas 4p2, and a port at a side of the bypath branch line for reactive gas 4p1 of the reactive gas middle line outlet valve 1b2 is closed and the reactive gas is sent out to the reactive gas middle line output part 13 so as to be in a state shown in Fig. 5. And the precursory gas is sent out to the bypath line 4 like the preliminary stage prior to forming the film and the reactive gas (H₂O) is supplied to the chamber 8. The state shown in Fig. 5 continues for about 0.5 second. The period is controlled by the acting time of the valve and it may be shorter.

Next, a thin film is formed by the reactive gas and then the reactive gas is purged.

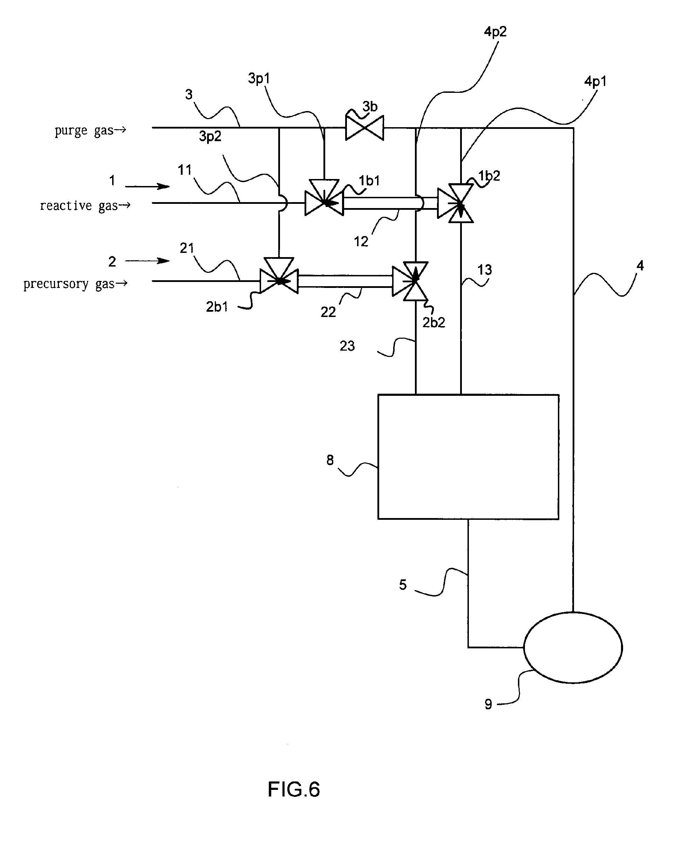

The purge gas is sent out to the reactive gas middle line 12 by closing the switching valve 3b and a port locating at a side of the reactive gas middle line input part 11 of the reactive gas middle line inlet valve 1b1 so as to be in a state shown in Fig. 6. Then the reactive gas (H₂O) of volume (15 ml) in the reactive gas middle line 12 is pushed out to the chamber 8 to form the thin film on the substrate and then inside of the reactive gas middle line 12, inside of the reactive gas middle line output part 13 and inside of the chamber 8 are purged. The state in Fig. 6 continues for about 5 second.

The precursory gas is filled in the precursory gas middle line 22 during a period from the initiation of supplying the reactive gas (H₂O) to the completion of purging the inside of the chamber 8.

A single cycle of supplying the precursory gas (TMA) and the reactive gas (H₂O) will be completed with the above process. Then the above process from the state shown in Fig. 3 to the state shown in Fig. 6 is repeated by supplying the precursory gas and the reactive gas alternately until a target thickness.

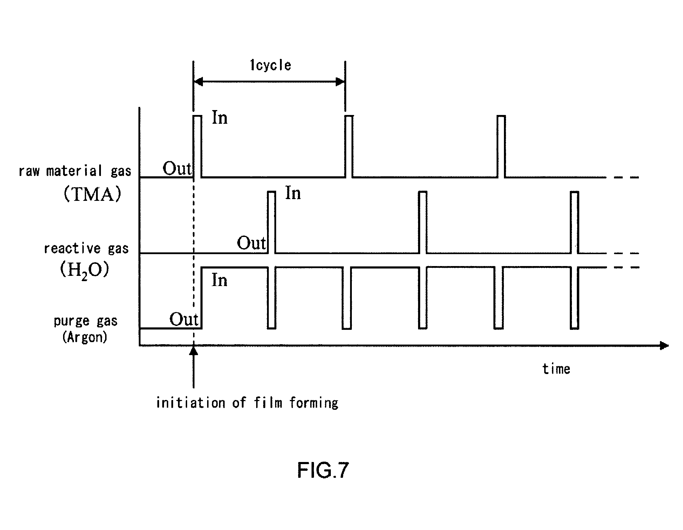

An image of a change over time of the gas supplied to the chamber 8 is shown in Fig. 7. The period required for supplying the precursory gas and the reactive gas can be made extremely short (rate controlled according to the speed of opening or closing the valve), which enables to increase the deposition rate extremely.

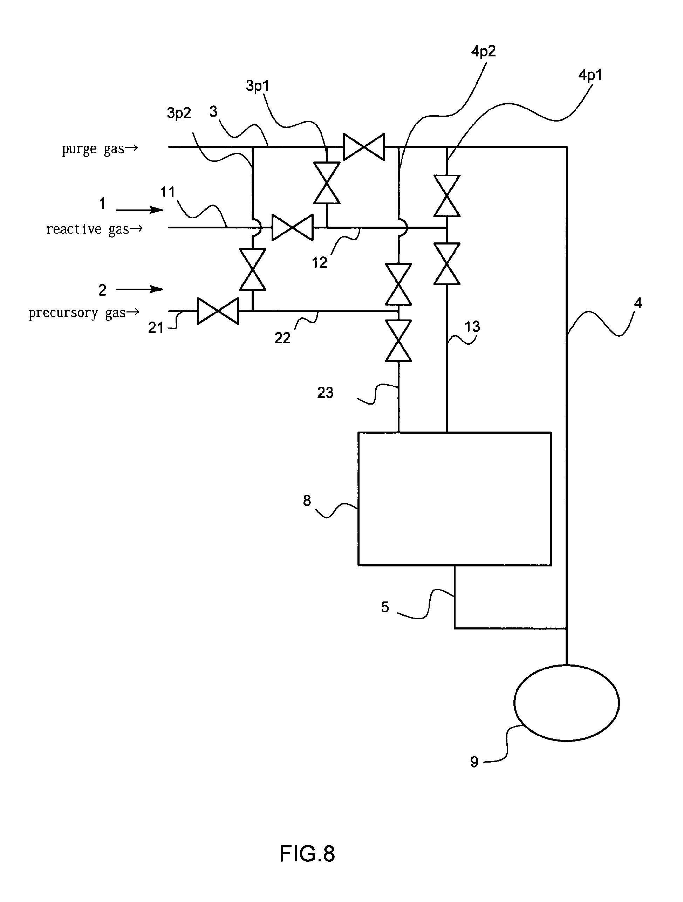

In this embodiment shown in Fig. 1, a type of the valve of each middle line inlet valve 1b1, 2b1, and each middle line outlet valve 1b2, 2b2 are the type of the three-way valve, however, it may be of a type having two ports as shown in Fig. 8. However, the three-way valve as being a furcated valve has no dead space at a connecting portion of the valve. Then if the three-way valve is used, the gas can be replaced smoothly. Since the gas is replaced steadily and smoothly, it is unlikely to generate particles. In addition, if the valve is a three-way magnetic valve, the valve can be driven at a high speed. This will be furthermore preferable.

In addition, comparison was made for three cases concerning the performance in this embodiment: with a length of the precursory gas middle line output part 23 from the precursory gas middle line outlet valve 2b2 to the chamber 8 set to be 100 mm and with an inside diameter of the precursory gas middle line output part 23 set to be 3.1 mm, 6.3 mm, and 9.4 mm.

Each inside volume of the precursory gas middle line output part 23 is 754 mm³, 3116 mm³ and 6936 mm³ respectively. Since the flow rate of the purge gas is 200 ml/min, it can be calculated 0.2 second, 0.93 second and 2.1 second to replace the inside of the precursory gas middle line output part 23. This period is short in comparison with the purge period of 5 second determined in this embodiment. If the gas replacement of the inside of the precursory gas middle line output part 23 is insufficient when the reactive gas is supplied to the chamber 8, the precursory gas is exposed to the reactive gas (H₂O). As a result, particles (fine particles of aluminum oxide) are generated inside the precursory gas middle line output part 23 and the surface of the substrate is contaminated.

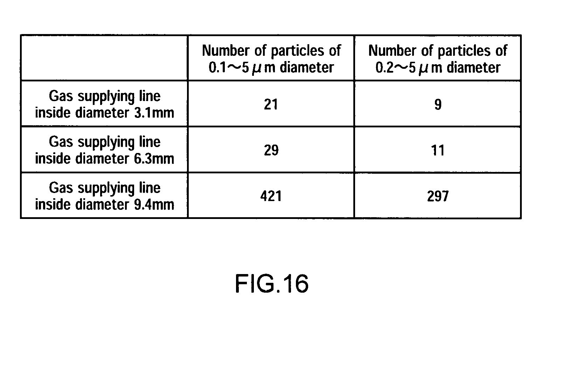

A number of particles that attach to a wafer is shown in Fig. 16 for each case of the inside diameter of the precursory gas supplying line 2. In case that the inside diameter is 9.4 mm, a considerable number of the particles are generated in comparison with the case that the inside diameter is 3.1 mm or 6.3 mm. According to this result, it is understandable that there might be a case replacement is insufficient due to the temperature or the viscosity of the gas even though the precursory gas middle line output part 23 that can replace the gas in 2.1 second is used for the purge period of about 5 second determined in this embodiment.

Generally, the period to flow the purge gas is elongated in order to avoid this problem. However, it will elongate the period required for film forming, thereby failing improvement of the throughput.

Consequently, in order to make it possible to purge the inside of the precursory gas middle line output part 23 by the use of the purge gas quickly and steadily, the volume of the precursory gas middle line output part 23 is adjusted so that the precursory gas middle line 22 and the precursory gas middle line output part 23 can be replaced with the purge gas in less than or equal to 2 second with keeping a condition that the period to flow the purge gas is about 5 second.

In addition, comparison was made for four cases of the performance in this embodiment: with the pressure in the chamber 8 of 0.1 Torr, 1 Torr, 10 Torr and 20 Torr.

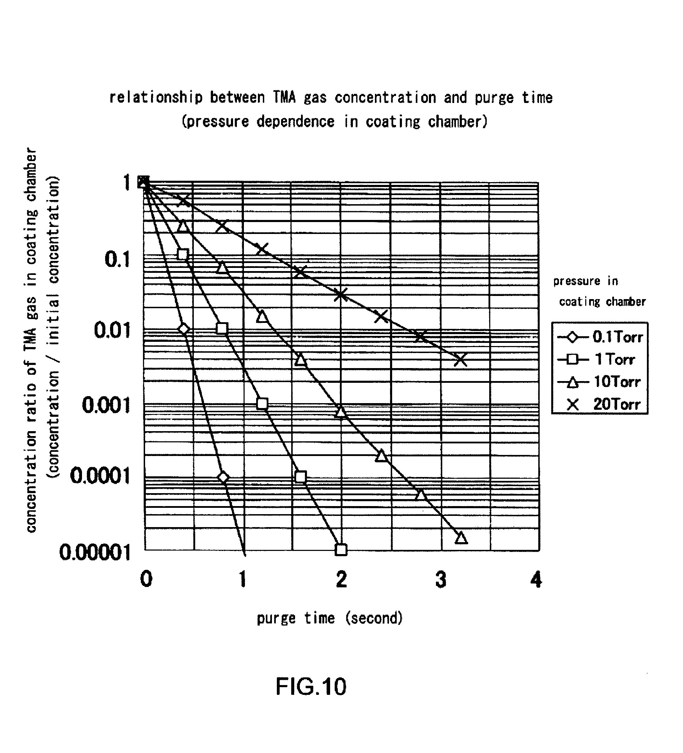

Generally the pressure in the chamber 8 is, as mentioned above, controlled to be 0.1 - 10 Torr. With this pressure, inside of the chamber 8 is replaced by the purge gas. A result concerning attenuation of the concentration of the precursory gas (TMA) is shown in Fig. 10. According to this result, the period to purge the gas was less than or equal to 2 second and the concentration of the precursory gas was less than or equal to 1/1000.

Under a condition that the concentration of the gas was over 1/1000, namely in case that the pressure in the chamber 8 was 20 Torr, if the gas was switched in 2 second, particles were generated and a number of the particles became more than or equal to about 800 pieces. This is because that the particles (particles of aluminum oxide) are generated due to reaction in a gaseous phase of the chamber 8 since the reactive gas (H₂O) is supplied to the chamber 8 under a condition that the replacement of the gas is insufficient.

In this case, generally the period to flow the purge gas is elongated. However, it will elongate the period required for film forming, thereby failing improvement of the throughput.

Consequently, in order to make it possible to purge the inside of the chamber 8 by the use of the purge gas quickly and steadily, it was found that the problem could be solved by purging the inside of the chamber 8 by the use of the purge gas in less than or equal to 2 second with the period to flow the purge gas kept about 5 second, and furthermore by making the concentration of the precursory gas less than or equal to 1/1000.

In order to solve the concrete problem concerning purge of the chamber 8, hardware should be selected appropriately because the volume of the chamber 8 that requires purge gas supply or the capacity of the pump 9 to depressurize the chamber 8 in order to discharge gas quickly from the chamber 8 have an influence on this problem. Then the hardware is appropriately selected so that the period required for purging the chamber 8 by the use of the purge gas is less than or equal to 2 second, the concentration of the precursory gas is less than or equal to 1/1000, and the purge time of the precursory gas middle line output part 23 is less than or equal to 2 second. This arrangement makes it possible to improve the throughput during the process of film forming and to produce the thin film of high quality at a low cost compared with a conventional technique.

In this embodiment, the volume of the chamber 8 is set to be about 2 L (2.2 L), and the pumping speed of the pump 9 is set to be about 280 m³/hr.

The above description is about the precursory gas supplying line 2, however, the same can be said for the reactive gas supplying line 1.

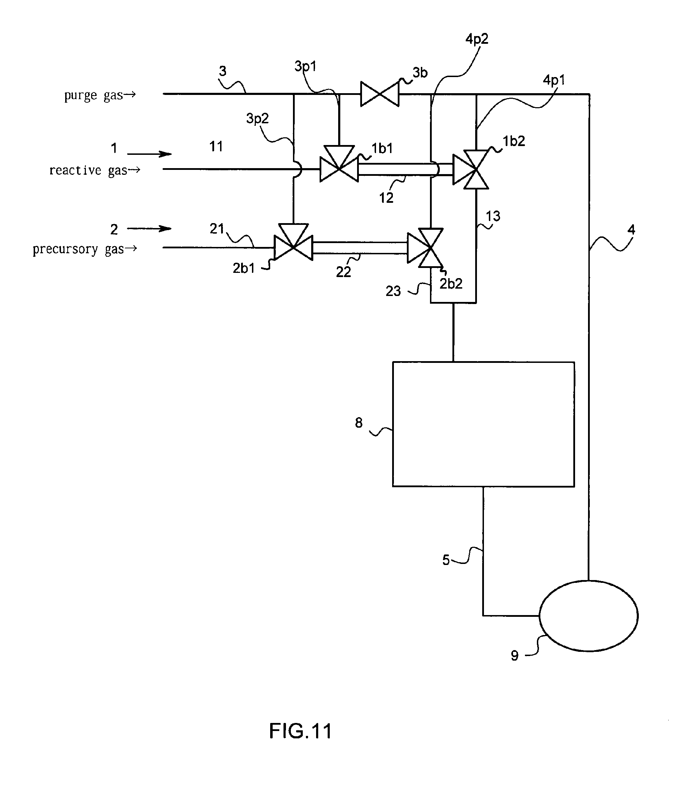

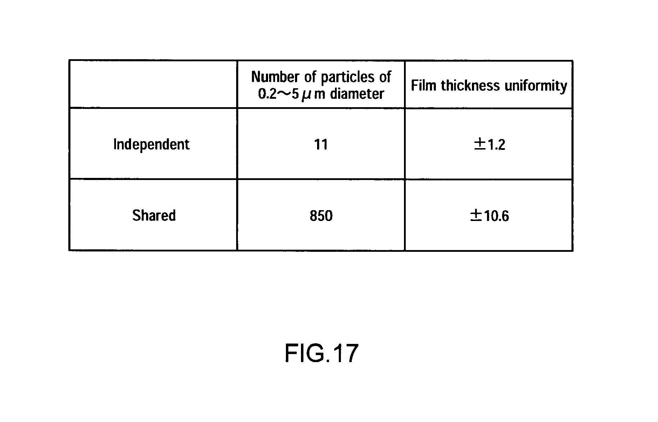

As shown in Fig. 1, each of the reactive gas (H₂O) supplying line 1 and the precursory gas (TMA) supplying line 2 is connected to the chamber 8 independently. In case of sharing a part of the chamber 8 including a connecting part by the precursory gas middle line output part 23 and the reactive gas middle line output part 13 so that each of the reactive gas supplying line 1 and the precursory gas supplying line 2 was mutually shared halfway as shown in Fig. 11, it was found that a lot of particles were generated as shown in Fig. 17 in comparison with a case that each of the reactive gas supplying line 1 and the precursory gas supplying line 2 was arranged independently. This is because the precursory gas molecule reacted with the reactive gas and metal oxide (in this case, aluminum oxide powder or its intermediate product) was generated so as to be the particles when the reactive gas flowed inside the line after the precursory gas molecule was absorbed into inside the shared line. In addition, as shown in Fig. 17, in a case that a part of the reactive gas supplying line 1 and the precursory gas supplying line 2 is shared, it was found that uniformity of the thin film was aggravated in comparison with a case each of the reactive gas supplying line 1 and the precursory gas supplying line 2 was arranged independently. This is because the intermediate product such as aluminum oxide was absorbed and deposited into the thin film so as to form an oxide film.

As mentioned above, since the metal oxide film that includes particles or whose thickness is uneven is insufficient in film density and mostly defective, quality of the thin film is aggravated.

As a result of this, it was found that the arrangement wherein the reactive gas supplying line 1 and the precursory gas supplying line 2 were independently connected to the chamber 8 was superior.

It was understood that it was not good to use a common line for the precursory gas and the reactive gas, and it was also understood that it was not good to use a common line for different kinds of the precursory gas.

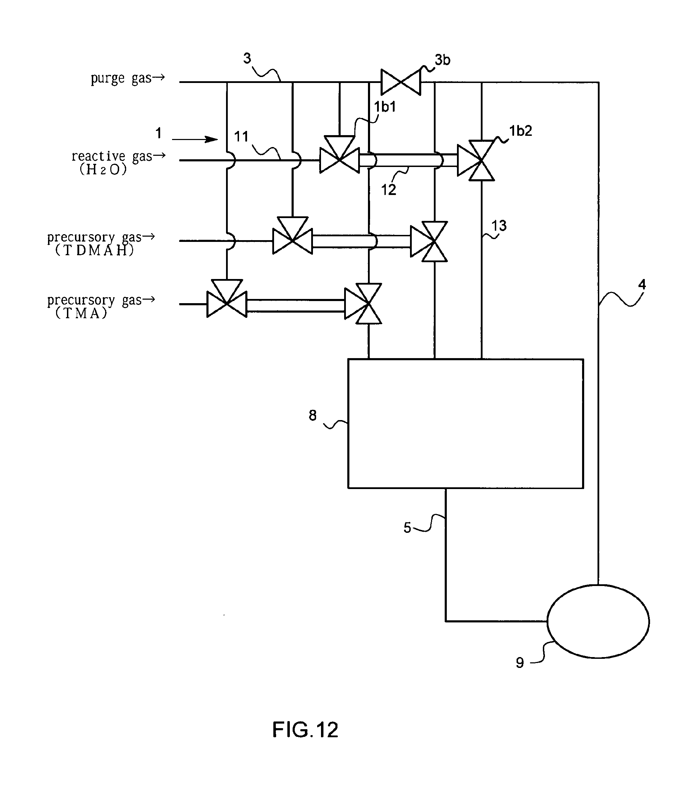

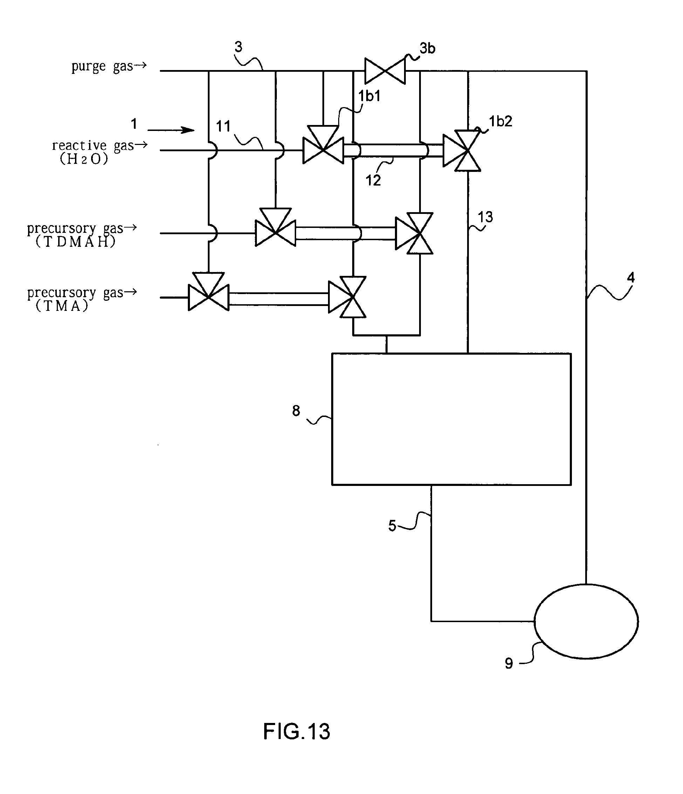

As an example to form a HfAlOx film as a compound oxide film, a schematic diagram of the system by the use of TMA and TDMAH (tetrakis dimethyl amino hafnium: Hf[N(CH₃)₂]₄) as the precursory gas and H₂O as the reactive gas is shown in Fig. 12 (in case that each of the precursory gas supplying lines is independently arranged) and Fig. 13 (in case that each of the precursory gas supplying lines is shared).

Since the precursor of TMA and the precursor of TDMAH react each other, there is a concern that particles are generated when the precursory gas supplying line is shared. As a result, it was found that the arrangement of the film forming system wherein each of the gas supplying lines was independently connected to the chamber was better since it could be selected freely without considering a combination of chemical compounds of the precursory gas.

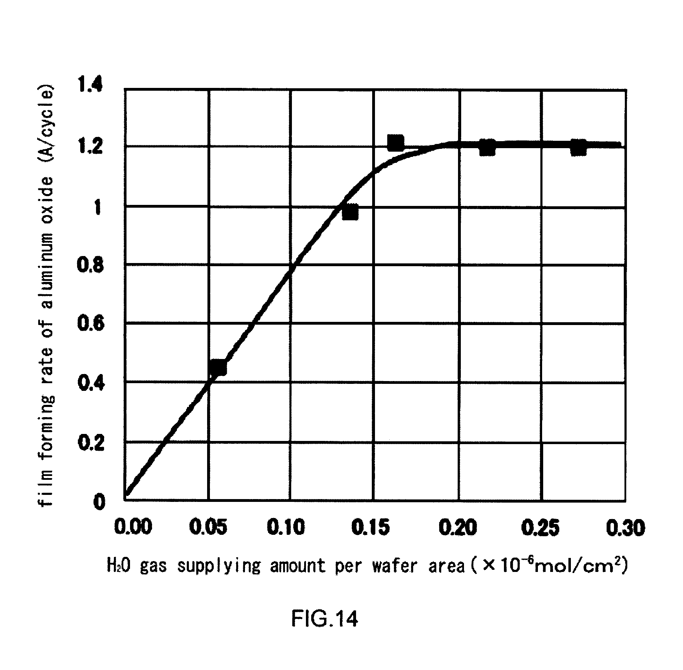

Under the condition of the above-mentioned embodiment, a Al₂O₃ film (aluminum oxide) was formed with changing an amount of the reactive gas (H₂O) to be supplied at a time. The result is shown in Fig. 14. A relationship between the amount of the reactive gas (H₂O) to be supplied and a deposition rate of the Al₂O₃ films is shown in Fig. 14. In accordance with an increase of the amount of the reactive gas (H₂O) to be supplied, the deposition rate was increased. In case that the amount of the reactive gas (H₂O) to be supplied was more than or equal to about 0.15 µmol/cm², the deposition rate became constant and saturated. As a result of this, it was found that the amount of the reactive gas (H₂O) to be supplied was required to be more than or equal to 0.15 µmol/cm². In case that the amount of the reactive gas to be supplied is insufficient, it can be presumed that the reaction is not fully completed and there is a concern that an impure substance resulting from the precursor, in this case mainly carbon of CH₃ (methyl group), resides in the thin film due to an insufficient hydrolysis reaction of TMA so that a quality of the thin film is aggravated.

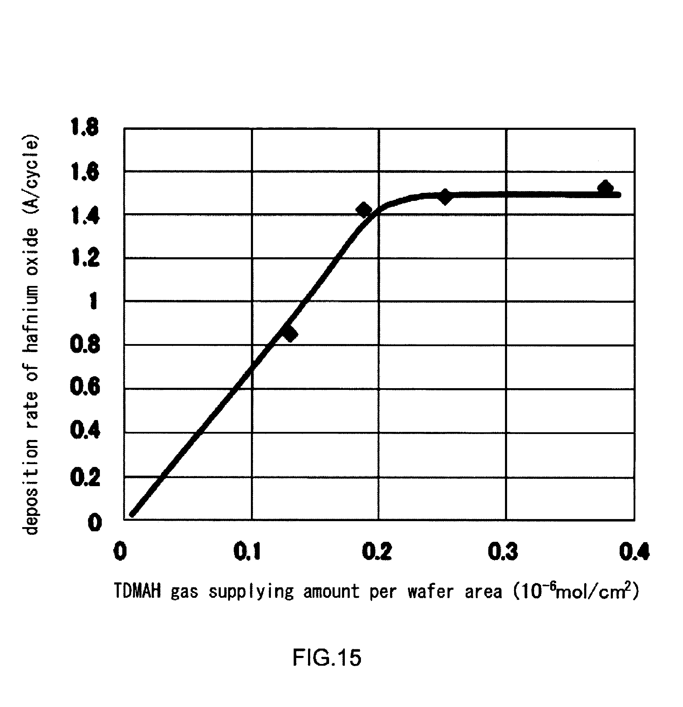

The above-mentioned is a case that the amount of the reactive gas to be supplied is changed, and a case that an amount of the precursory gas to be supplied is changed also will be described. In case of forming a HfO₂ film (hafnium oxide) with TDMAH used as the precursory gas and H₂O used as the reactive gas, the HfO₂ film was formed with changing an amount of the TDMAH gas to be supplied at a time. A result of this is shown in Fig. 15. In accordance with an increase of the amount of the TDMAH gas to be supplied, the deposition rate was increased. In case that the amount of the TDMAH gas to be supplied was more than or equal to about 0.2 µmol/cm², the deposition rate became constant and saturated. As a result of this, it was found that the amount of the TDMAH gas to be supplied was required to be more than or equal to 0.2 µmol/cm². In case that the amount of the TDMAH gas to be supplied is insufficient, there is a concern that a distribution of the thin film becomes aggravated due to uneven supply of the precursory gas.

As mentioned above, the amount of the precursory gas and the reactive gas to be supplied is required to be controlled. As a device to control the amount of the gas to be supplied, there is a method for controlling the concentration of the gas to be supplied by adjusting the pressure of the inside of the middle line 12, 22 by the use of a pump 91, 92 individually in case of filling the gas to each of the middle lines 12, 22.

A concrete arrangement of the film forming system comprising the concentration adjusting device will be described as follows.

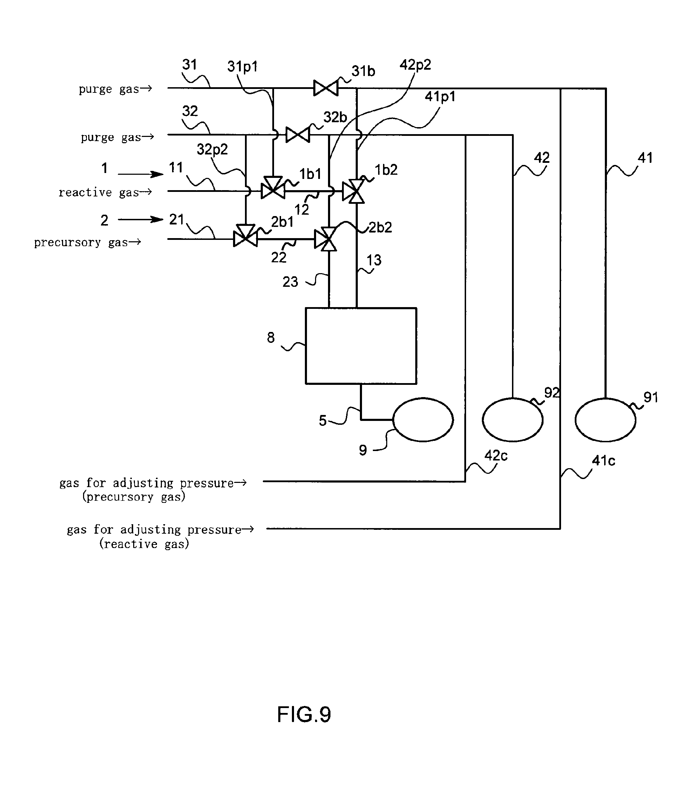

As shown in Fig. 9, a pressure adjusting pump for precursory gas 92 and a pressure adjusting pump for reactive gas 91 are arranged as the concentration adjusting device, a bypath line for reactive gas 41 connected to the pressure adjusting pump for reactive gas 91 and a bypath line for precursory gas 42 connected to the pressure adjusting pump for precursory gas 92 are arranged as a line to be connected to each of the pressure adjusting pump for precursory gas 92 and the pressure adjusting pump for reactive gas 91, and a pressure adjusting line for reactive gas 41c connected to the bypath line for reactive gas 41 and a pressure adjusting line for precursory gas 42c connected to the bypath line for precursory gas 42 are arranged as a line to be connected to each of the bypath line for reactive gas 41 and the bypath line for precursory gas 42.

In order to connect the concentration adjusting device to the chamber 8, the bypath line 4 is removed from the arrangement of the above-mentioned embodiment and the purge gas supplying line 3 is divided into a purge gas supplying line for reactive gas 31 and a purge gas supplying line for precursory gas 31.

In addition, as an alteration of connecting the lines, first the purge gas supplying line for reactive gas 31 and the bypath line for reactive gas 41 are connected through a switching valve 31b, the purge gas supplying line for precursory gas 32 and the bypath line for precursory gas 42 are connected through a switching valve 32b, and next as an alteration of connecting each branch line 31p1, 41p1, 32p2, 42p2, the purge gas supplying branch line for reactive gas 31p1 is connected to the purge gas supplying line for reactive gas 31 and the reactive gas middle line inlet valve 1b1, the bypath branch line for reactive gas 41p1 is connected to the bypath line for reactive gas 41 and the reactive gas middle line outlet valve 1b2, the purge gas supplying branch line for precursory gas 32p2 is connected to the purge gas supplying line for precursory gas 32 and the precursory gas middle line inlet valve 2b1, and the bypath branch line for precursory gas 42p2 is connected to the bypath line for precursory gas 42 and the precursory gas middle line outlet valve 2b2.

In order to adjust the concentration by the use of the film forming system comprising the concentration adjusting device, the reactive gas is continuously sent to the pressure adjusting line for reactive gas 41c and the precursory gas is continuously sent to the pressure adjusting line for precursory gas 42c. Then the concentration of the reactive gas and the concentration of the precursory gas can be made to be a desired constant value at a time of filling the reactive gas and the precursory gas into the reactive gas middle line 12 and the precursory gas middle line 22, and the concentration of the reactive gas and the concentration of the precursory gas at a time when each gas is supplied to the chamber can be made more than or equal to 0.15 µmol/cm².

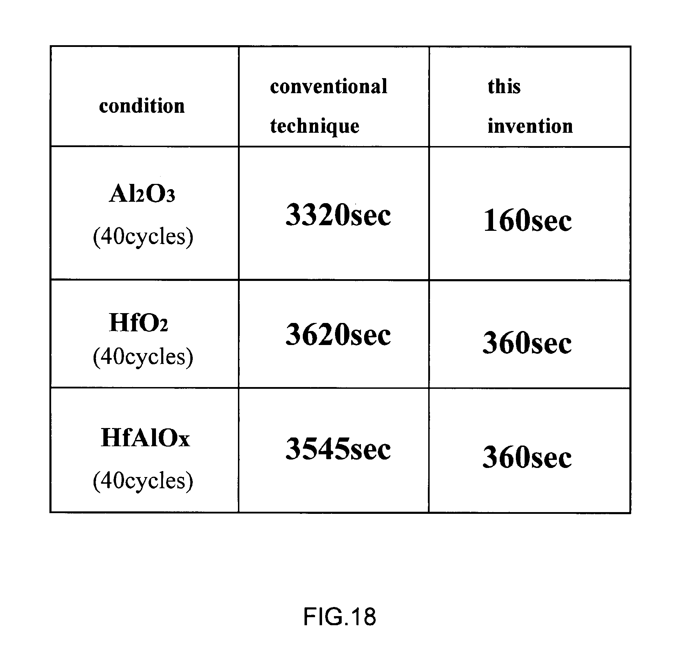

Fig. 18 is a table showing a comparison result of the throughput in accordance with this invention and the throughput in accordance with a conventional arrangement. The table shows a time required for film forming three different kinds of thin films, namely the time required for conducting 40 cycles for Al₂O₃, 40 cycles for HfO₂, and 40 cycles for HfAlOx. (Refer to Fig. 7 with regard to a cycle)

In accordance with the table, it is found that the throughput of the film forming system that makes use of this invention is considerably improved in comparison with the film forming system that makes use of a conventional technique.

### POSSIBLE APPLICATIONS IN INDUSTRY

In accordance with this invention, a thin film of high quality can be formed in a short time without generating particle, and if this invention is applied especially to semiconductor equipment a very dramatic effect can be obtained such that a gate insulating film, a gate electrode film and a capacitor insulating film of high quality can be formed in a short time with a low cost.

## Claims

1. A film forming system comprising a chamber, a precursory gas supplying line to supply the chamber with precursory gas, a reactive gas supplying line to supply the chamber with reactive gas, and a purge gas supplying line to supply purge gas that purges the precursory gas and the reactive gas, and that forms a thin film on a substrate in the chamber by supplying the precursory gas or the reactive gas and purging alternately, wherein further comprising a middle line having a certain volume that is arranged on a part or all of the precursor supplying line and into which the precursory gas can be filled at a time when the precursory gas is not supplied, and/or a middle line having a certain volume that is arranged on a part or all of the reactive gas supplying line and into which the reactive gas can be filled at a time when the reactive gas is not supplied.

2. The film forming system described in claim 1, wherein a switching valve is arranged on an inlet port and an outlet port of the middle line respectively so as to specify a volume of the middle line with the cross-sectional area of a line body constituting the middle line and a distance between each of the switching valves.

3. The film forming system described in claim 2, wherein the switching valve is a three-way valve.

4. The film forming system described in claim 1, wherein the purge gas supplying line is connected to the precursory gas supplying line to which the middle line is arranged and/or the reactive gas supplying line to which the middle line is arranged and the precursory gas and/or the reactive gas each of which is filled in the middle line is supplied to the chamber by pushing out the precursory gas and/or the reactive gas by the use of the purge gas.

5. The film forming system described in claim 1, wherein the precursory gas and/or the reactive gas is supplied to the chamber in 0.1 through 2 second.

6. The film forming system described in claim 1, wherein a concentration adjusting device to adjust each concentration of the precursory gas and the reactive gas is connected to the precursory gas supplying line and the reactive gas supplying line respectively and each concentration adjusting device adjusts each concentration of the precursory gas and the reactive gas so as to supply each gas at more than or equal to 0.15 × 10⁻⁶ mol/cm² with respect to an area of the substrate on which the thin film is formed.

7. The film forming system described in claim 1, wherein each of the precursory gas supplying line and the reactive gas supplying line is independently connected to the chamber.

8. The film forming system described in claim 1, and that is arranged to purge the chamber so that each concentration of the precursory gas and/or the reactive gas becomes less than or equal to 1/1000 in less than or equal to 2 seconds.

9. A film forming method that makes use of a chamber, a precursory gas supplying line to supply the chamber with precursory gas, a reactive gas supplying line to supply the chamber with reactive gas, and a purge gas supplying line to supply purge gas that purges the precursory gas and the reactive gas and that forms a thin film on a substrate in the chamber by supplying the precursory gas or the reactive gas and purging alternately, wherein a middle line having a certain volume is arranged on a part or all of the precursor supplying line and the precursory gas is filled into the middle line at a time when the precursory gas is not supplied, and/or a middle line having a certain volume is arranged on a part or all of the reactive gas supplying line and the reactive gas is filled into the middle line at a time when the reactive gas is not supplied.
